# EUROPEAN PATENT APPLICATION

(11) **EP 4 804 742 A1**
(43) Date of publication of application: **09.09.2026**
(21) Application number: 24920571.7
(22) Date of filing: 28.11.2024
(51) Int. Cl.: H05K 5/04, H05K 5/00, H04M 1/02, B22F 3/22, B22F 3/16, G06F 1/16, B22F 7/06

(54) **ELECTRONIC DEVICE COMPRISING HOUSING ASSEMBLY INCLUDING FRAME AND BRACKET, AND MANUFACTURING METHOD THEREFOR**

(30) Priority: 23.01.2024 KR 20240010520; 14.02.2024 KR 20240021383
(71) Applicant: Samsung Electronics Co., Ltd., Suwon-si, Gyeonggi-do 16677 (KR)
(72) Inventor: LEE, Hosoon, Suwon-si Gyeonggi-do 16677 (KR); CHOI, Hyunsuk, Suwon-si Gyeonggi-do 16677 (KR)
(74) Representative: Gulde & Partner
(86) International application number: PCT/KR2024/019209
(87) International publication number: WO 2025/159320

(57) **Abstract**

This electronic device comprises a housing assembly. The housing assembly includes: a rear cover that defines the rear surface of the electronic device; a frame attached to the rear cover and formed of a first metal material; and a bracket which includes a support portion and which is formed of a second metal material that differs from the first metal material. The frame includes: a first portion for defining the side surfaces of the electronic device; and a second portion disposed on the inner surface of the first portion. The electronic device comprises a display supported by the support portion. The second portion of the frame is disposed between the first portion of the frame and the support portion of the bracket. A portion of the second metal material of the bracket is inserted into some air gaps included in the second portion.

## Description

### [Technical Field]

The present disclosure relates to an electronic device including a housing assembly including a frame and a bracket, and a method of manufacturing the same.

### [Background Art]

An electronic device may include a housing assembly defining an exterior of the electronic device. The housing assembly may include a frame defining a side surface of the electronic device, a rear cover defining a rear surface of the electronic device, and a bracket surrounded by the frame. The bracket may support components positioned inside the electronic device (e.g., a battery and a printed circuit board) and a display. The bracket may be coupled to the frame. For rigidity of the housing assembly, the frame and the bracket may include a metal material. For example, the metal material may include titanium, stainless steel, aluminum, and/or magnesium. The frame and the bracket may include metal materials different from each other.

The above-described information may be provided as related art for the purpose of helping the understanding of the present disclosure. No claim or determination is raised as to whether any of the above-described content may be applied as prior art related to the present disclosure.

### [Disclosure]

### [Technical Solution]

An electronic device is provided. The electronic device may comprise a housing assembly. The housing assembly may include a rear cover defining a rear surface of the electronic device. The housing assembly may include a frame attached to the rear cover and formed from a first metal material. The frame may include a first portion defining a side surface of the electronic device. The frame may include a second portion disposed on an inner surface of the first portion. The housing assembly may include a bracket including a supporting portion and formed from a second metal material different from the first metal material. The electronic device may comprise a display supported by the supporting portion. The second portion of the frame may be disposed between the first portion and the supporting portion. A portion of the second metal material of the bracket may be inserted into some of pores included in the second portion.

A method of manufacturing a housing assembly is provided. The manufacturing method may comprise injecting a first mixture of first metal powders and binder using a first mold to form a first portion. The manufacturing method may comprise separating the first portion from the first mold. The manufacturing method may comprise placing the first portion in a second mold. The manufacturing method may comprise forming a second portion on an inner surface of the first portion by injecting a second mixture of the first metal powders and binder using the second mold. The manufacturing method may comprise performing de-binding to remove the binder included in the first portion and the binder included in the second portion such that an amount of the binder remaining in the second portion is greater than an amount of the binder remaining in the first portion. The manufacturing method may comprise forming a frame by performing sintering to the first portion and the second portion after the de-binding is performed. The manufacturing method may comprise placing the frame in a third mold. The manufacturing method may comprise forming a bracket by die casting of molten second metal using the third mold with the frame placed therein to integrally form the bracket to an inner side of the second portion of the frame. The second mixture may have a ratio of the binder to the first metal powders that is greater than a ratio of the binder to the first metal powders of the first mixture.

### [Description of the Drawings]

FIG. 1 is a block diagram of an electronic device in a network environment according to an embodiment.
FIG. 2 illustrates an electronic device according to an example embodiment.
FIG. 3 is an exploded perspective view of an electronic device according to an example embodiment.
FIG. 4A illustrates an example of a housing assembly of an electronic device including a frame and a bracket.
FIG. 4B illustrates a frame according to an example embodiment.
FIG. 4C illustrates a bracket according to an example embodiment.
FIG. 5 illustrates an example of a cross-sectional view of the housing assembly of FIG. 4A cut along line A-A'.
FIG. 6 is a flow chart illustrating an example of a process of manufacturing a housing assembly including a frame and a bracket.
FIG. 7A illustrates a first mold for forming the first portion.
FIG. 7B illustrates the first portion formed by operation 601.
FIG. 8A illustrates a second mold for forming the second portion.
FIG. 8B illustrates the frame formed by operation 603 of FIG. 6.
FIG. 9A illustrates an example structure of a first portion and a second portion after metal injection molding.
FIG. 9B illustrates an example structure of the first portion and the second portion after a de-binding process.
FIG. 9C illustrates an example structure of the first portion and the second portion after a sintering process.
FIG. 10 illustrates an operation of forming a bracket.
FIG. 11A illustrates a housing assembly in which a frame and a bracket are formed.
FIG. 11B illustrates the housing assembly in which resin is injected into the frame.
FIG. 11C illustrates the housing assembly of a final product obtained by processing the shape of the housing assembly of FIG. 11B.

### [Mode for Invention]

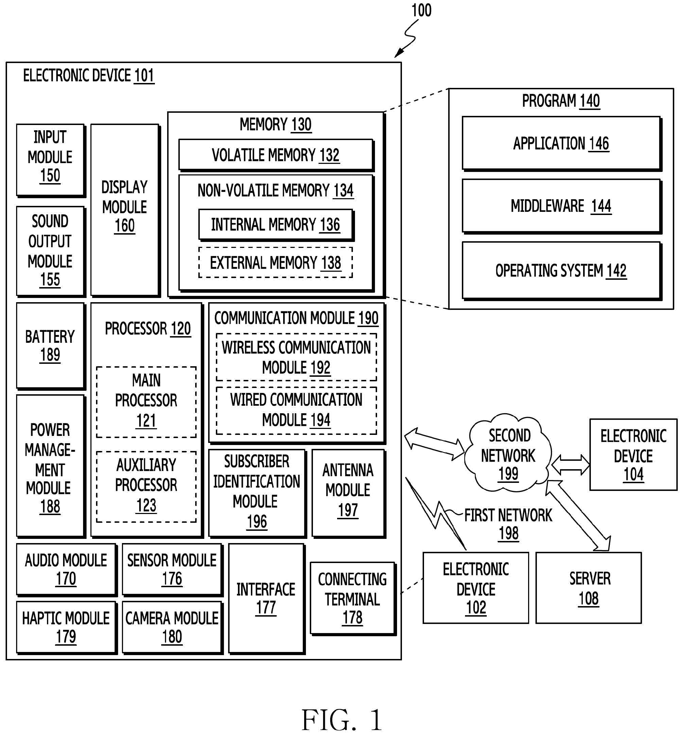

FIG. 1 is a block diagram illustrating an electronic device 101 in a network environment 100 according to an embodiment.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

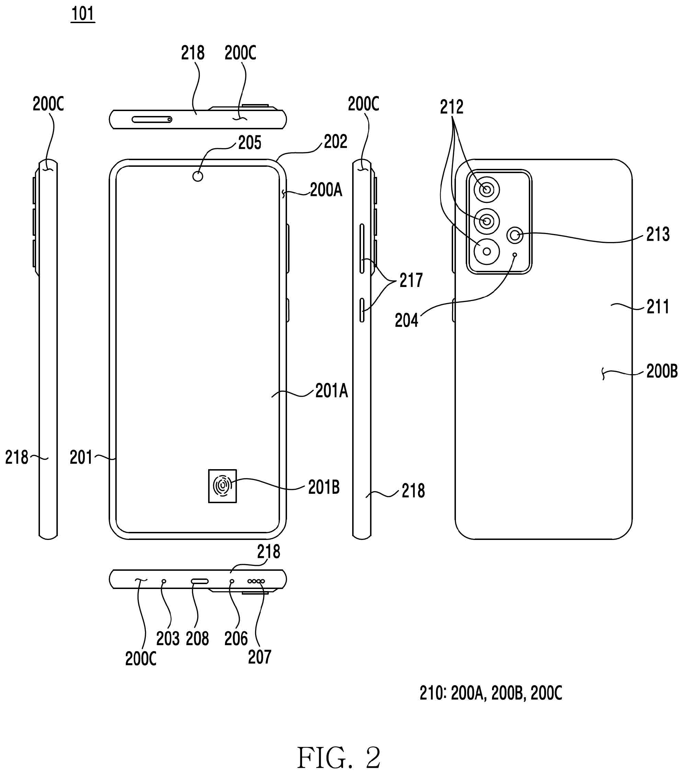

FIG. 2 illustrates an electronic device according to an example embodiment.

Referring to FIG. 2, an electronic device 101 according to an example embodiment may include a housing assembly 210 forming an exterior of the electronic device 101. For example, the housing assembly 210 may include a first surface (or a front surface) 200A, a second surface (or a rear surface) 200B, and a third surface (or a side surface) 200C surrounding a space between the first surface 200A and the second surface 200B.

The electronic device 101 according to an example embodiment may include a substantially transparent front cover 202. According to an example embodiment, the front cover 202 may form at least a portion of the first surface 200A. According to an example embodiment, the front cover 202 may include, for example, a glass plate, or a polymer plate including various coating layers, but is not limited thereto.

The electronic device 101 according to an example embodiment may include a substantially opaque rear cover 211. According to an example embodiment, the rear cover 211 may form at least a portion of the second surface 200B. According to an example embodiment, the rear cover 211 may be formed of coated or colored glass, ceramic, polymer, metal (e.g., aluminum, stainless steel (STS), or magnesium), or a combination of at least two of the materials.

The electronic device 101 according to an example embodiment may include a frame 218. According to an example embodiment, the frame 218 may be coupled with the front cover 202 and/or the rear cover 211 to form at least a portion of the third surface 200C of the electronic device 101. For example, the frame 218 may form the entire third surface 200C of the electronic device 101. For example, the frame 218 may form the third surface 200C of the electronic device 101 together with the front cover 202 and/or the rear cover 211.

The electronic device 101 according to an example embodiment may include at least one of a display 201, an audio module 203, 204, and 207, a sensor module (not illustrated), camera modules 205, 212, and 213, a key input device 217, a light emitting element (not illustrated), and/or a connector hole 208. According to an example embodiment, the electronic device 101 may omit at least one (e.g., the key input device 217 or the light emitting element (not illustrated)) of the components or additionally include another component.

According to an example embodiment, at least a portion of the display 201 (e.g., the display module 160 of FIG. 1) may be visible through the front cover 202 forming the first surface 200A. According to an example embodiment, the display 201 may be disposed on a back surface of the front cover 202.

According to an example embodiment, an outer shape of the display 201 may be formed to be substantially the same as an outer shape of the front cover 202 adjacent to the display 201. According to an example embodiment, in order to expand an area in which the display 201 is visually exposed, a gap between an outer edge of the display 201 and an outer edge of the front cover 202 may be formed to be substantially the same.

According to an example embodiment, the display 201 (or the first surface 200A of the electronic device 101) may include a screen display area 201A. According to an example embodiment, the display 201 may provide visual information to a user through the screen display area 201A. In the illustrated embodiment, when the first surface 200A is viewed from the front, the screen display area 201A is illustrated as being spaced apart from an outer edge of the first surface 200A and positioned on an inner side of the first surface 200A, but is not limited thereto. According to an example embodiment, when the first surface 200A is viewed from the front, at least a portion of an edge of the screen display area 201A may substantially coincide with an edge of the first surface 200A (or the front cover 202).

According to an example embodiment, the screen display area 201A may include a sensing area 201B configured to obtain biometric information of the user. Herein, the expression "the screen display area 201A includes the sensing area 201B" may be understood to mean that at least a portion of the sensing area 201B may be overlapped with the screen display area 201A. For example, the sensing area 201B may refer to an area capable of displaying visual information by the display 201 like another area of the screen display area 201A, and may additionally refer to an area capable of obtaining biometric information (e.g., a fingerprint) of the user. According to an example embodiment, the sensing area 201B may be formed in the key input device 217.

According to an example embodiment, the display 201 may include an area in which a first camera module 205 (e.g., the camera module 180 of FIG. 1) is positioned. According to an example embodiment, an opening may be formed in the area of the display 201, and the first camera module 205 (e.g., a punch-hole camera) may be at least partially disposed in the opening to face the first surface 200A. In this case, the screen display area 201A may surround at least a portion of an edge of the opening. According to an example embodiment, the first camera module 205 (e.g., an under display camera (UDC)) may be disposed below the display 201 to overlap with the area of the display 201. In this case, the display 201 may provide visual information to the user through the area, and additionally, the first camera module 205 may obtain an image corresponding to a direction toward the first surface 200A through the area of the display 201.

According to an example embodiment, the display 201 may be coupled with or disposed adjacent to touch sensing circuitry, a pressure sensor capable of measuring intensity (pressure) of a touch, and/or a digitizer detecting a magnetic field type stylus pen.

According to an example embodiment, the audio module 203, 204, and 207 (e.g., the audio module 170 of FIG. 1) may include microphone holes 203 and 204 and/or a speaker hole 207.

According to an example embodiment, the microphone holes 203 and 204 may include a first microphone hole 203 formed in a partial area of the third surface 200C and/or a second microphone hole 204 formed in a partial area of the second surface 200B. A microphone (not illustrated) for obtaining external sound may be disposed inside the microphone holes 203 and 204. The microphone may include a plurality of microphones to detect a direction of sound.

According to an example embodiment, the second microphone hole 204 formed in the partial area of the second surface 200B may be disposed adjacent to the camera modules 205, 212, and 213. For example, the second microphone hole 204 may obtain sound according to an operation of the camera modules 205, 212, and 213. However, it is not limited thereto.

According to an example embodiment, the speaker hole 207 may include an external speaker hole 207 and a receiver hole for calls (not illustrated). The external speaker hole 207 may be formed in a portion of the third surface 200C of the electronic device 101. According to an example embodiment, the external speaker hole 207 may be implemented as one hole together with the microphone hole 203. Although not illustrated, the receiver hole for calls (not illustrated) may be formed in another portion of the third surface 200C. For example, the receiver hole for calls may be formed on an opposite side of the external speaker hole 207 on the third surface 200C. For example, based on the illustration of FIG. 2, the external speaker hole 207 may be formed on the third surface 200C corresponding to a lower end portion of the electronic device 101, and the receiver hole for calls may be formed on the third surface 200C corresponding to an upper end portion of the electronic device 101. However, it is not limited thereto, and according to an example embodiment, the receiver hole for calls may be formed at a position other than the third surface 200C. For example, the receiver hole for calls may be formed by a separated space between the front cover 202 (or the display 201) and the frame 218.

According to an example embodiment, the electronic device 101 may include at least one speaker (not illustrated) configured to output sound to an outside of the housing assembly 210 through the external speaker hole 207 and/or the receiver hole for calls (not illustrated).

According to an example embodiment, the sensor module (not illustrated) (e.g., the sensor module 176 of FIG. 1) may generate an electrical signal or a data value corresponding to an operating state inside the electronic device 101 or an environmental state outside the electronic device 101. For example, the sensor module may include at least one of a proximity sensor, an HRM sensor, a fingerprint sensor, a gesture sensor, a gyro sensor, a barometric pressure sensor, a magnetic sensor, an acceleration sensor, a grip sensor, a color sensor, an infrared (IR) sensor, a biometric sensor, a temperature sensor, a humidity sensor, or an illuminance sensor.

According to an example embodiment, the camera modules 205, 212, and 213 (e.g., the camera module 180 of FIG. 1) may include a first camera module 205 disposed to face the first surface 200A of the electronic device 101, a second camera module 212 disposed to face the second surface 200B, and a flash 213.

According to an example embodiment, the second camera module 212 may include a plurality of cameras (e.g., a dual camera, a triple camera, or a quad camera). However, the second camera module 212 is not necessarily limited to including a plurality of cameras, and may include one camera.

According to an example embodiment, the first camera module 205 and the second camera module 212 may include one or a plurality of lenses, an image sensor, and/or an image signal processor.

According to an example embodiment, the flash 213 may include, for example, a light emitting diode or a xenon lamp. According to an example embodiment, two or more lenses (an infrared camera, wide-angle lens, and telephoto lens) and image sensors may be disposed on one surface of the electronic device 101.

According to an example embodiment, the key input device 217 (e.g., the input module 150 of FIG. 1) may be disposed on the third surface 200C of the electronic device 101. According to an example embodiment, the electronic device 101 may not include some or all of the key input device 217, and the key input device 217 that is excluded may be implemented in another form, such as a soft key, on the display 201.

According to an example embodiment, the connector hole 208 may be formed on the third surface 200C of the electronic device 101 so that a connector of an external device may be accommodated. A connecting terminal (e.g., the connecting terminal 178 of FIG. 1) electrically connected to the connector of the external device may be disposed in the connector hole 208. The electronic device 101 according to an example embodiment may include an interface module (e.g., the interface 177 of FIG. 1) for processing an electrical signal transmitted and received through the connecting terminal.

According to an example embodiment, the frame 218 may include a vent hole 206. For example, air outside the housing assembly 210 may be introduced into the housing assembly 210 through the vent hole 206. For example, air inside the housing assembly 210 may be discharged to the outside of the housing assembly 210 through the vent hole 206. A position of the vent hole 206 is not limited to the position illustrated in FIG. 2.

According to an example embodiment, the electronic device 101 may include a light emitting element (not illustrated). For example, the light emitting element (not illustrated) may be disposed on the first surface 200A of the housing assembly 210. The light emitting element (not illustrated) may provide state information of the electronic device 101 in a form of light. According to an example embodiment, the light emitting element (not illustrated) may provide a light source linked with operation of the first camera module 205. For example, the light emitting element (not illustrated) may include an LED, an IR LED, and/or a xenon lamp.

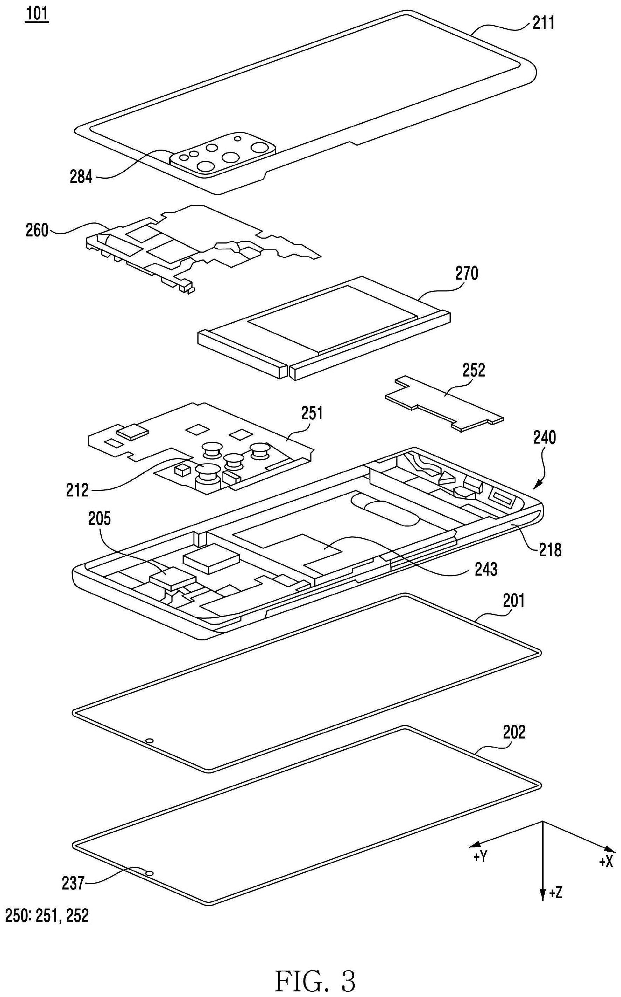

FIG. 3 is an exploded perspective view of an electronic device according to an example embodiment.

Hereinafter, redundant descriptions of components having the same reference numerals as those described above will be omitted.

Referring to FIG. 3, an electronic device 101 according to an example embodiment may include a frame 218, a bracket 243, a printed circuit board (PCB) 250, a cover plate 260, and/or a battery 270. The PCB 250 may include a first PCB 251, which is a main board, and a second PCB 252, which is a sub-board.

The electronic device 101 according to an example embodiment may include the frame 218 forming an exterior (e.g., the third surface 200C of FIG. 2) of the electronic device 101 and the bracket 243 extending inward from the frame 218. According to an example embodiment, the frame 218 and the bracket 243 may be disposed between a display 201 and a rear cover 211. For example, the frame 218 may surround a space between the rear cover 211 and a front cover 202 (and/or the display 201). For example, the bracket 243 may extend from the frame 218 within the space.

According to an example embodiment, the bracket 243 may support or accommodate other components included in the electronic device 101. For example, the display 201 may be disposed on a surface of the bracket 243 facing a direction (e.g., a +z direction), and the display 201 may be supported by a supporting portion of the bracket 243. For example, the first PCB 251, the second PCB 252, the battery 270, and a second camera module 212 may be disposed on another surface of the bracket 243 facing a direction opposite to the direction (e.g., a -z direction). For example, the first PCB 251, the second PCB 252, the battery 270, and the second camera module 212 may be respectively seated in a recess defined by the frame 218 and/or the bracket 243.

According to an example embodiment, the first PCB 251, the second PCB 252, and the battery 270 may be coupled to the bracket 243, respectively. For example, the first PCB 251 and the second PCB 252 may be fixedly disposed on the bracket 243 through a coupling member such as a screw. For example, the battery 270 may be fixedly disposed on the bracket 243 through an adhesive member (e.g., double-sided tape). However, it is not limited to the above-described example.

According to an example embodiment, the cover plate 260 may be disposed between the first PCB 251 and the rear cover 211. According to an example embodiment, the cover plate 260 may be disposed on the first PCB 251. For example, the cover plate 260 may be disposed on a surface of the first PCB 251 facing the -z direction.

According to an example embodiment, the cover plate 260 may at least partially overlap the first PCB 251 with respect to the z-axis. According to an example embodiment, the cover plate 260 may cover at least a partial area of the first PCB 251. Through this, the cover plate 260 may protect the first PCB 251 from physical impact or prevent detachment of a connector coupled to the first PCB 251.

According to an example embodiment, the cover plate 260 may be fixedly disposed on the first PCB 251 through a coupling member (e.g., a screw), or may be coupled to the bracket 243 together with the first PCB 251 through the coupling member.

According to an example embodiment, the display 201 may be disposed between the bracket 243 and the front cover 202. For example, the front cover 202 may be disposed on a side (e.g., the +z direction) of the display 201, and the bracket 243 may be disposed on another side (e.g., the -z direction).

According to an example embodiment, the front cover 202 may be coupled to the display 201. For example, the front cover 202 and the display 201 may be adhered to each other through an optical adhesive member (e.g., optically clear adhesive (OCA) or optically clear resin (OCR)) interposed therebetween.

According to an example embodiment, the front cover 202 may be coupled to the frame 218. For example, when viewed in a z-axis direction, the front cover 202 may include an outer portion extending outward from the display 201, and may be adhered to the frame 218 through an adhesive member (e.g., waterproof tape) disposed between the outer portion of the front cover 202 and the frame 218. However, it is not limited to the above-described example.

According to an example embodiment, a processor (e.g., the processor 120 of FIG. 1), memory (e.g., the memory 130 of FIG. 1), and/or an interface (e.g., the interface 177 of FIG. 1) may be disposed on the first PCB 251 and/or the second PCB 252. The processor may include, for example, one or more of a central processing unit, an application processor, a graphics processing unit, an image signal processor, a sensor hub processor, or a communication processor. The memory may include, for example, a volatile memory or a non-volatile memory. The interface may include, for example, a high definition multimedia interface (HDMI), a universal serial bus (USB) interface, an SD card interface, and/or an audio interface. The interface may electrically or physically connect the electronic device 101 to an external electronic device, and may include a USB connector, an SD card/MMC connector, or an audio connector. According to an example embodiment, the first PCB 251 and the second PCB 252 may be operatively or electrically connected to each other through a connecting member (e.g., a flexible printed circuit board).

According to an example embodiment, the battery 270 (e.g., the battery 189 of FIG. 1) may supply power to at least one component of the electronic device 101. For example, the battery 270 may include a rechargeable secondary cell or a fuel cell. At least a portion of the battery 270 may be disposed substantially on the same plane as the first PCB 251 and/or the second PCB 252.

The electronic device 101 according to an example embodiment may include an antenna module (not illustrated) (e.g., the antenna module 197 of FIG. 1). According to an example embodiment, the antenna module may be disposed between the rear cover 211 and the battery 270. The antenna module may include, for example, a near field communication (NFC) antenna, a wireless charging antenna, and/or a magnetic secure transmission (MST) antenna. The antenna module may, for example, perform short-range communication with an external device or wirelessly transmit and receive power with an external device.

According to an example embodiment, a first camera module 205 (e.g., a front camera) may be disposed on at least a portion of the bracket 243 such that a lens may receive external light through a partial area (e.g., a camera area 237) of the front cover 202 (e.g., the front surface 200A of FIG. 2).

According to an example embodiment, the second camera module 212 (e.g., a rear camera) may be disposed between the bracket 243 and the rear cover 211. According to an example embodiment, the second camera module 212 may be electrically connected to the first PCB 251 through a connecting member (e.g., a connector). According to an example embodiment, the second camera module 212 may be disposed such that a lens may receive external light through a camera area 284 of the rear cover 211 of the electronic device 101.

According to an example embodiment, the camera area 284 may be formed on a surface (e.g., the rear surface 200B of FIG. 2) of the rear cover 211. According to an example embodiment, the camera area 284 may be formed to be at least partially transparent such that external light may be incident on the lens of the second camera module 212. According to an example embodiment, at least a portion of the camera area 284 may protrude from the surface of the rear cover 211 by a predetermined height. However, it is not limited thereto, and according to an example embodiment, the camera area 284 may form substantially the same plane as the surface of the rear cover 211.

According to an example embodiment, a housing assembly 210 of the electronic device 101 may refer to a configuration or structure forming at least a portion of the exterior of the electronic device 101. In this regard, at least a portion of the front cover 202, the frame 218, the bracket 243, and/or the rear cover 211 forming the exterior of the electronic device 101 may be referred to as the housing assembly 210 of the electronic device 101.

The electronic device 101 described below may include a housing assembly 210 including dissimilar metals. According to an example embodiment, the frame 218 may include a first metal material, and the bracket 243 may include a second metal material. In examples described below, the first metal material is described as titanium and the second metal material is described as aluminum, but it is not limited thereto.

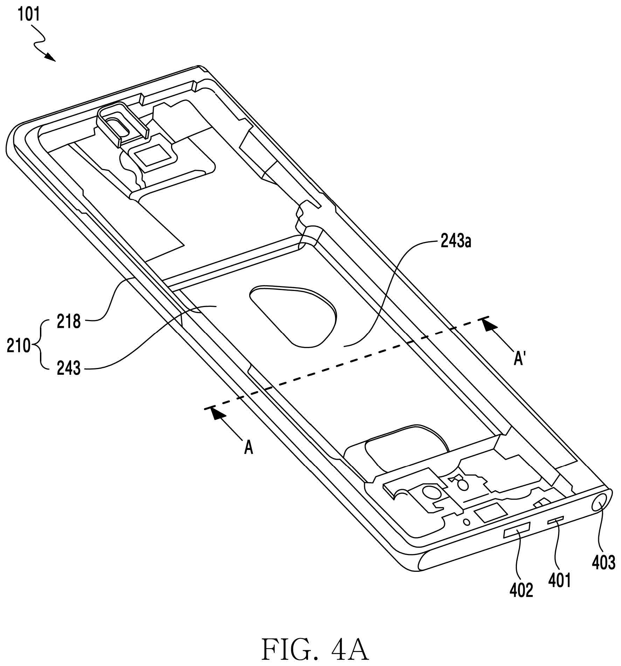

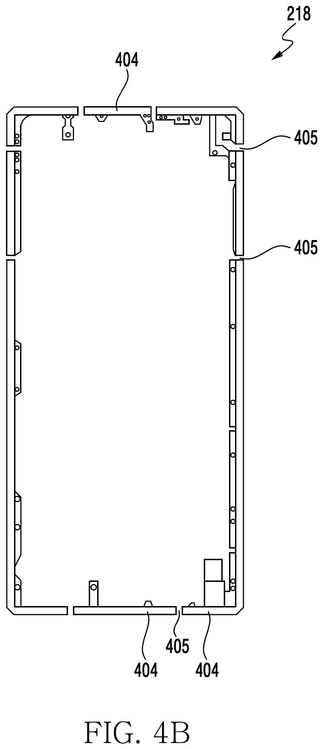

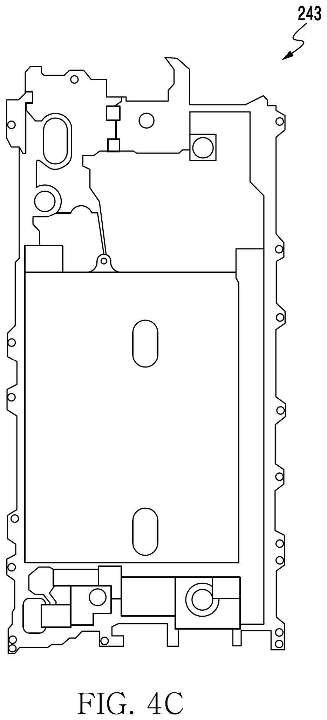

FIG. 4A illustrates an example of a housing assembly of an electronic device including a frame and a bracket. FIG. 4B illustrates a frame according to an example embodiment. FIG. 4C illustrates a bracket according to an example embodiment.

Referring to FIG. 4A, an electronic device 101 according to an example embodiment may include a housing assembly 210 forming an exterior. The housing assembly 210 may include a frame 218 at least partially defining a side surface of the electronic device 101 and a bracket 243 supporting a display (e.g., the display 201 of FIG. 3) and/or electronic components.

According to an example embodiment, the frame 218 may form at least a portion of the side surface of the electronic device 101. For example, the frame 218 may be coupled to a front cover (e.g., the front cover 202 of FIG. 3) at least partially forming a front surface of the electronic device 101 and a rear cover (e.g., the rear cover 211 of FIG. 3) at least partially forming a rear surface of the electronic device 101. The frame 218 may form an internal space of the electronic device 101 by surrounding a space between the front cover and the rear cover. For example, the frame 218 may include a speaker hole 401 for providing an audio signal to an outside of the electronic device 101, a connector hole 402 for coupling a connector of an external electronic device, and/or a hole 403 capable of accommodating an electronic pen (e.g., a stylus pen). The frame 218 may be referred to as a bezel structure or a side structure in terms of defining the side surface of the electronic device 101.

According to an example embodiment, the bracket 243 may be configured to support components of the electronic device 101. For example, the display (e.g., the display 201 of FIG. 3) may be supported by a supporting portion 243a of the bracket 243. For example, the supporting portion 243a of the bracket 243 may be a portion of the bracket 243 that is not coupled to the frame 218 and is spaced apart from the frame 218. For example, electronic components such as a printed circuit board (PCB) (e.g., the PCB 250 of FIG. 3), a battery (e.g., the battery 270 of FIG. 3), and a camera (e.g., the second camera module 212 of FIG. 3) may be supported by the bracket 243 by being disposed on the bracket 243. According to an example embodiment, the bracket 243 may be at least partially surrounded by the frame 218. The bracket 243 may be coupled to an inner surface of the frame 218. The bracket 243 may be referred to as a supporting member or a supporting plate in terms of supporting components of the electronic device 101.

According to an example embodiment, each of the frame 218 and the bracket 243 may be manufactured by a separate process. Referring to FIG. 4B, the frame 218 may have a substantially quadrilateral ring shape including an empty space therein. At least a portion of the frame 218 may include one or more conductive portions 404 in order to operate as an antenna radiator used for communication with an external electronic device. When the one or more conductive portions 404 operate as an antenna radiator, a resonance frequency of a signal transmitted and/or received through the one or more conductive portions 404 may be determined based on an electrical length of the one or more conductive portions 404. For example, when a wavelength corresponding to the resonance frequency of the signal is λ, the electrical length of the one or more conductive portions 404 for transmitting and/or receiving a signal having the resonance frequency may be 1/4 λ to 1/2 λ. In order to adjust the electrical length of the one or more conductive portions 404, the frame 218 may include a slot 405 (or a slit). The slot 405 (or slit) may be filled with a non-conductive material to determine the electrical length of the one or more conductive portions 404 operating as the antenna radiator and to electrically isolate the one or more conductive portions 404 from another conductive portion.

According to an example embodiment, since the frame 218 at least partially forms the side surface of the electronic device 101, it may be exposed to an outside of the electronic device 101. Since the frame 218 forms a portion of an outer surface of the electronic device 101, it may be required to have relatively high strength, hardness, and excellent surface characteristics in order to protect components of the electronic device 101 from an external impact. When strength of the frame 218 is low, the electronic device 101 may be easily damaged by an external impact, thereby causing damage to internal electronic components. When surface characteristics of the frame 218 are poor, the frame 218 may be easily corroded, resulting in deterioration of surface quality of the electronic device 101. For high strength and excellent surface characteristics, the frame 218 may include a first metal material having high strength and excellent surface characteristics. The frame 218 may be manufactured by injection molding first metal powders and binder into a mold including a cavity having a shape of the frame 218 (metal injection molding (MIM)) . For example, the first metal material may include titanium and/or stainless steel having high strength and excellent corrosion resistance. However, it is not limited thereto.

Referring to FIG. 4C, the bracket 243 may be coupled to an inner side of the frame (e.g., the frame 218 of FIG. 4B) by metal injection molding. Since the bracket 243 supports electronic components, the bracket 243 may be required to have relatively high strength. When the bracket 243 is manufactured of the same first metal material as the frame (e.g., the frame 218 of FIG. 4B), total weight of the electronic device 101 may become excessively heavy. For example, when the bracket 243 is manufactured of titanium, like the frame 218, the total weight of the electronic device 101 may increase. Since density of titanium (e.g., approximately 4.5g/cm³) is lower than that of metal materials such as iron and stainless steel but higher than density of aluminum (e.g., approximately 2.7g/cm³), an increase in the weight of the electronic device 101 may be caused by relatively high specific gravity of titanium. When the weight of the electronic device 101 is excessively heavy, a problem of deterioration in portability of the electronic device 101 may be caused.

According to an example embodiment, the bracket 243 may include a metal material different from that of the frame 218. For example, the bracket 243 may include a second metal material that is relatively lighter than the first metal material included in the frame 218. Unlike the frame 218, the bracket 243 surrounded by the frame 218 may not be exposed to an outside of the electronic device 101 and may be disposed inside the electronic device 101 by being at least partially surrounded by the frame 218. Since the bracket 243 is disposed inside the electronic device 101, even when the bracket 243 has lower strength than the frame 218, an influence on rigidity of the electronic device 101 may be small. According to an example embodiment, the second metal material may include aluminum and/or magnesium, which are relatively lighter than the first metal material (e.g., titanium). However, it is not limited thereto. Since specific gravity of aluminum is lower than specific gravity of titanium, an electronic device 101 including the bracket 243 including aluminum may be lighter than an electronic device 101 including the bracket 243 including titanium.

According to an example embodiment, the frame 218 and the bracket 243 may be manufactured by separate processes. Coupling strength between the frame 218 and the bracket 243 may require a degree of coupling strength such that they are not easily separated by an external impact. For example, the coupling strength between the frame 218 and the bracket 243 may be required to be approximately 10 MPa or more.

A coupling process of the frame 218 and the bracket 243 may vary. For example, after separately manufacturing the frame 218 and the bracket 243, a process of welding the bracket 243 to the frame 218 may be possible. A process of welding dissimilar metals may include Laser Welding, Electron-Beam Welding, and/or Friction Stir Welding. In a case of a process of coupling the frame 218 and the bracket 243 by welding, bubbles may be generated inside the frame 218 and/or the bracket 243 during the welding process. For example, when a difference in melting points between the first metal material included in the frame 218 and the second metal material included in the bracket 243 is large, the welding process may be performed at a temperature equal to or higher than the higher melting point. In this case, vaporization of the metal having the lower melting point may be caused by the temperature at which the welding process is performed. As the metal including the relatively lower melting point is vaporized, gas may be generated. The gas may cause generation of bubbles inside during the welding process. For example, when the first metal material is titanium and the second metal material is aluminum, a melting point of titanium is approximately 1,668°C, and a melting point of aluminum is approximately 660°C. Since the welding process may be performed at a temperature equal to or higher than the melting point of titanium (e.g., approximately 1,668°C), the temperature at which the welding process is performed may be too high relative to the melting point of aluminum. Due to the high temperature, aluminum may be vaporized and gas may be generated, and bubbles may be generated by the gas. Due to the generation of bubbles, an irregular coupling surface may be formed. When the coupling surface is irregular, weakening of the coupling strength may be caused. In addition, in the case of the welding process, since an additional welding process is required after separately manufacturing the frame 218 and the bracket 243, an increase in manufacturing time and manufacturing cost may be caused.

As a coupling process between the frame 218 and the bracket 243, a die casting process may be possible. In a case of the die casting process, by casting the second metal material forming the bracket 243 on the inner side of the frame 218, the bracket 243 coupled to the frame 218 may be formed. When the frame 218 and the bracket 243 include different metals, coupling force between the frame 218 and the bracket 243 may be weak due to a difference in physical properties and a difference in chemical properties between dissimilar metals. In order to improve coupling force between dissimilar metals (e.g., titanium and aluminum), a special treatment may be required on a coupling surface. For example, by adjusting roughness of the inner surface of the frame 218 using a method such as Laser Hatching or Blasting, a concavo-convex portion may be formed, and by infiltrating aluminum into the concavo-convex portion, the bracket 243 may be coupled to the frame 218. In a case of the above process, since a process for forming the concavo-convex portion may be required at a temperature equal to or higher than the melting point of titanium (e.g., approximately 1,668°C), there may be difficulty in controlling the temperature at which the process is performed.

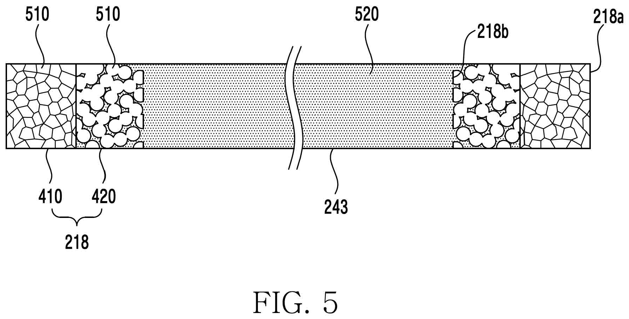

According to an example embodiment, by forming pores on an inner side of the frame 218 and die casting molten second metal such that the second metal material infiltrates into the pores, the bracket 243 coupled to the frame 218 may be formed. In a case of the above process, a problem of generation of bubbles caused by the welding process may be solved. When the bracket 243 is formed by die casting, even when roughness of the frame 218 is not adjusted to form a concavo-convex portion, the second metal material may naturally infiltrate into a portion of the frame 218 (e.g., a second portion 420 of FIG. 5) and the bracket 243 coupled to the inner side of the frame 218 may be formed.

FIG. 5 illustrates an example of a cross-sectional view of the housing assembly of FIG. 4A cut along line A-A'.

Referring to FIG. 5, a frame 218 may include a first portion 410 and a second portion 420. According to an example embodiment, the first portion 410 and the second portion 420 may include a first metal material 510. As described above, since the frame 218 is exposed to an outside of an electronic device (e.g., the electronic device 101 of FIG. 4A), the first metal material 510 may include titanium having relatively high strength, but is not limited thereto.

A surface 218a of the frame 218 facing the outside of the electronic device 101 is an outer surface of the frame 218, and a surface 218b of the frame 218 facing an inside of the electronic device 101 is an inner surface of the frame 218. According to an example embodiment, the first portion 410 may at least partially form the outer surface of the frame 218. The second portion 420 may at least partially form the inner surface of the frame 218. The first portion 410 may be disposed on the second portion 420. The second portion 420 may be a portion of the frame 218 coupled to a bracket 243. As will be described below, the first portion 410 and the second portion 420 may be manufactured separately. For example, thickness of the second portion 420 may be approximately 10% to approximately 70% of total thickness of the frame 218, but is not limited thereto.

According to an example embodiment, the bracket 243 may be formed inside the frame 218. For example, the frame 218 may have a substantially quadrilateral ring shape with an empty interior. The bracket 243 may at least partially fill the empty interior of the frame 218. The bracket 243 may be coupled to the second portion 420. For example, a portion of the bracket 243 may be coupled to the frame 218 by being included in the second portion 420.

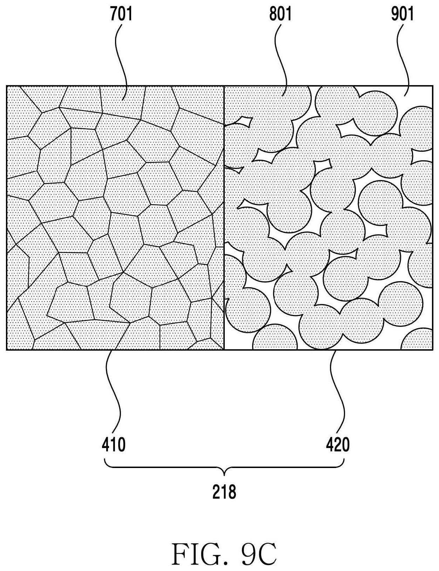

According to an example embodiment, the first portion 410 may substantially not include pores, and the second portion 420 may include pores (e.g., pores 901 of FIG. 9C). The difference may result from a difference in binder content during a process of manufacturing the frame 218. For example, when binder content is relatively large, pores may be formed as the binder remains during a sintering process. In a case of the first portion 410, first metal powders may be crystallized as the binder is fully vaporized during the sintering process. As the first metal powders are crystallized, the first portion 410 that at least partially forms the outer surface of the frame 218 may have a relatively uniform and smooth surface, and thus may have relatively high strength.

According to an example embodiment, the bracket 243 may be formed by die casting a second metal material 520 into the second portion 420 including the pores. In the die casting process, the second metal material 520 may infiltrate into pores between crystals of the first metal material 510. The second metal material 520 may infiltrate into the pores of the second portion 420, fill the pores, and then may be solidified through a cooling process. As the second metal material 520 is solidified in a state of having infiltrated into the pores, a portion of the bracket 243 may be included in the second portion 420. The second metal material 520 infiltrated into the pores may become a portion that couples the bracket 243 to the second portion 420. For coupling between the bracket 243 and the frame 218, even when a separate concavo-convex portion is not formed in the frame 218, the bracket 243 may be firmly coupled to the frame 218 by the second metal material 520 infiltrated into the pores. According to an example embodiment, the electronic device 101 having high coupling strength between the frame 218 and the bracket 243 may be provided.

According to an example embodiment, the bracket 243 may substantially not be included in the first portion 410. The second metal material 520 may infiltrate into the pores formed in the second portion 420, but may not be included in the first portion 410 since pores are substantially not formed in the crystallized first portion 410. In the final manufactured electronic device 101, the frame 218 may include the first portion 410 defining the outer surface and the second portion 420 including a portion of the bracket 243. Since the second portion 420 and the first portion 410 include the same first metal material 510, physical and chemical properties of an interface between the second portion 420 and the first portion 410 may be substantially the same. Even without a separate treatment process for coupling the second portion 420 and the first portion 410, the first portion 410 and the second portion 420 may be coupled by high coupling force. In a case of the first metal material 510 and the second metal material 520, which are dissimilar metals, it may be difficult to have high coupling force because they have different physical and chemical properties. According to an example embodiment, as the second metal material 520 infiltrates into the pores of the second portion 420, the bracket 243 may be firmly coupled to the second portion 420. Through the structure, since the bracket 243 and the frame 218 may have high coupling strength, rigidity of the electronic device 101 may be improved. For example, the coupling strength between the frame 218 and the bracket 243 may be at least approximately 10 MPa or more.

According to an example embodiment, density of the first metal material 510 included in the second portion 420 and density of the first metal material 510 included in the first portion 410 may be different. For example, the density of the first metal material 510 included in the second portion 420 may be lower than the density of the first metal material 510 included in the first portion 410. As described above, since the first metal material 510 included in the first portion 410 may be fully crystallized, the density of the first metal material 510 included in the first portion 410 may exhibit relatively high density. In a case of the second portion 420, since pores may be formed by the binder, the density of the first metal material 510 included in the second portion 420 may exhibit relatively low density.

According to an example embodiment, a size of crystals of the first metal material 510 included in the second portion 420 and a size of crystals of the first metal material 510 included in the first portion 410 may be different. For example, the size of the crystals of the first metal material 510 included in the second portion 420 may be smaller than the size of the crystals of the first metal material 510 included in the first portion 410. Since binder included in the first portion 410 is fully vaporized during a de-binding process, the first metal material 510 included in the first portion 410 may be substantially fully crystallized during the de-binding process. Since binder included in the second portion 420 does not fully vaporize during the sintering process and remains, a space occupied by the binder may exist in the second portion 420.

Hereinafter, a process of manufacturing the frame 218 and the bracket 243 having the structure illustrated in FIG. 5 is described.

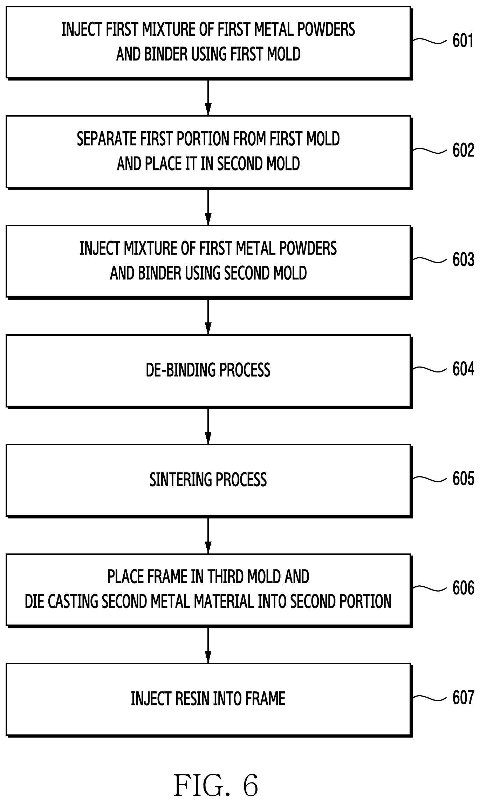

FIG. 6 is a flow chart illustrating an example of a process of manufacturing a housing assembly including a frame and a bracket.

Operations described in FIG. 6 may be referred to as a manufacturing method for manufacturing a housing assembly (e.g., the housing assembly 210 of FIG. 4A) of the electronic device (e.g., the electronic device 101 of FIG. 4A) described above. The electronic device 101 described above has been described as the electronic device 101 including a bar-type housing assembly 210, but is not limited thereto. For example, the manufacturing method of FIG. 6 may be referred to as a method for manufacturing not only the bar-type housing assembly 210, but also a foldable-type housing or a rollable-type housing. Each of the following operations represents a process of manufacturing the housing assembly 210 of the electronic device 101, and may be referred to as a step or a process.

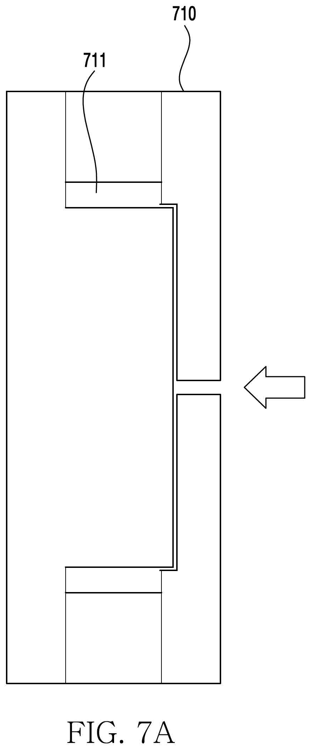

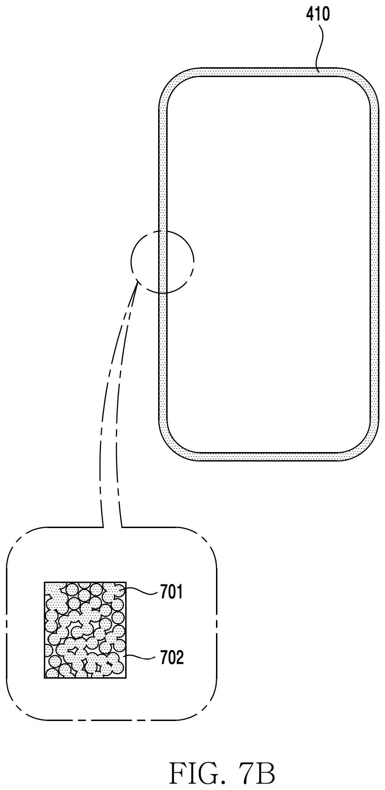

Referring to FIG. 6, in operation 601, a first portion (e.g., the first portion 410 of FIG. 7B) may be formed by injecting a first mixture of first metal powders and binder using a first mold (e.g., the first mold 710 of FIG. 7A).

FIG. 7A illustrates a first mold for forming the first portion.

Referring to FIG. 7A, the first mold 710 may be used to form the first portion (e.g., the first portion 410 of FIG. 7B). The first mold 710 illustrated in FIG. 7A is merely a mold schematically illustrated to describe the manufacturing method, and an embodiment is not limited to the drawing illustrated in FIG. 7A. The first mold 710 is a mold including a cavity 711 corresponding to a shape of the first portion 410 of a frame (e.g., the frame 218 of FIG. 4B), and may have a shape corresponding to an outer shape of the frame 218. To form the first portion 410, first metal powders (e.g., first metal powders 701 of FIG. 7B) and a first binder (e.g., a first binder 702 of FIG. 7B) may be mixed. A first mixture to be injected into the first mold 710 may be prepared by mixing the first metal powders and the first binder. A ratio of the first binder to the first metal powders of the first mixture injected into the first mold 710 may be referred to as a first ratio. The first ratio may be referred to as a relatively low ratio compared with a second ratio described below. For example, the first ratio may be approximately 5wt% to approximately 15wt% with respect to the first metal powders of the first mixture injected into the first mold 710, but is not limited thereto. For example, a ratio of the binder to the first metal powders of the first mixture may be referred to as approximately 5wt% to approximately 15wt%. The first binder may include polyethylene (PE), polypropylene (PP), stearic acid, or a mixed resin, but is not limited thereto. As described above, the first metal material may include titanium. The first portion 410 may be formed as titanium powders and the first binder having the first ratio are injected into the cavity 711 of the first mold 710.

FIG. 7B illustrates the first portion formed by operation 601.

Referring to FIG. 7B, the first portion 410 may at least partially form an outer surface of the frame 218. As the first metal powders 701 are coupled by the first binder 702, a shape of the first portion 410 may be formed. The first portion 410 may include an outer edge defining the outer surface of the frame 218, and an interior of the first portion 410 may be empty. As illustrated in FIG. 7B, the first portion 410 may have a substantially quadrilateral ring shape with an empty interior.

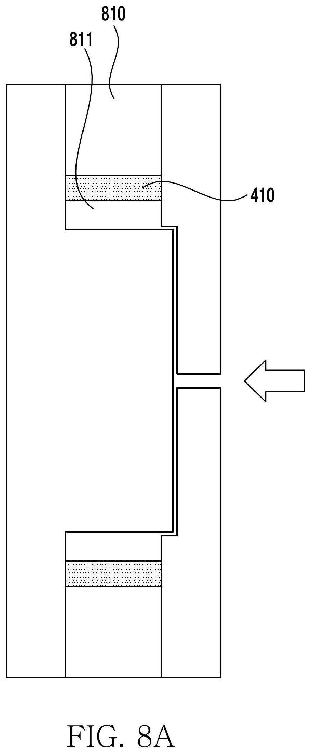

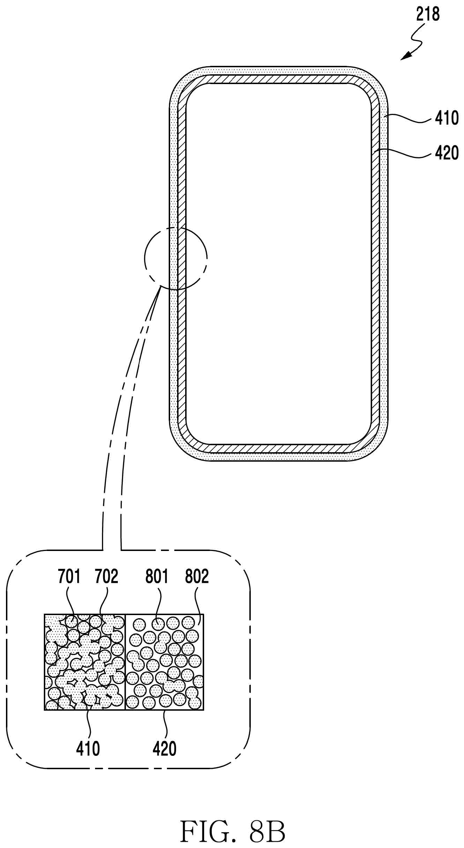

Referring again to FIG. 6, in operation 602, the first portion 410 may be separated from the first mold 710 and may be placed in a second mold (e.g., the second mold 810 of FIG. 8A) for forming a second portion (e.g., a second portion 420 of FIG. 8B). For example, the shape of the first portion 410 may be maintained by the first metal powders 701 coupled by the first binder 702. The first portion 410 may maintain the shape even when separated from the first mold 710. The separated first portion 410 may be placed in the second mold 810. To additionally form the second portion 420 on the first portion 410 formed by operation 601, the first portion 410 separated from the first mold 710 may be placed in the second mold 810.

In operation 603, the second portion 420 may be formed by injecting a second mixture of the first metal powders and binder using the second mold 810.

FIG. 8A illustrates a second mold for forming the second portion.

Referring to FIG. 8A, the second mold 810 may be used to form the second portion 420. The second mold 810 illustrated in FIG. 8A is merely a mold schematically illustrated to describe the manufacturing method, and an embodiment is not limited to the drawing illustrated in FIG. 8A. The second mold 810 is a mold including a cavity 811 corresponding to a shape of the second portion 420 of the frame 218, and the cavity 811 may have a shape corresponding to an inner shape of the frame 218. To form the second portion 420, first metal powders (e.g., first metal powders 801 of FIG. 8B) and a second binder (e.g., a second binder 802 of FIG. 8B) may be mixed. As described above, the first metal material may include titanium. The second portion 420 may be formed as titanium powders and the second binder 802 having the second ratio are injected into the cavity 811 of the second mold 810. The second portion 420 may be additionally formed on an inner surface of the first portion 410 placed in the second mold 810. In the present disclosure, the first binder 702 is used as a term to describe binder injected into the first mold 710 to form the first portion 410, and the second binder 802 is used as a term to describe binder injected into the second mold 810 to form the second portion 420. The first binder 702 and the second binder 802 may be the same material having different ratios and may include, for example, a mixed resin.

FIG. 8B illustrates the frame formed by operation 603 of FIG. 6.

Referring to FIG. 8B, the second portion 420 may at least partially form an inner surface of the frame 218. The second portion 420 may be formed on the inner surface the first portion 410. The second portion 420 may include an inner edge forming the inner surface of the frame 218, and an interior of the second portion 420 may be empty.

According to an example embodiment, as the first metal powders 801 and the second binder 802 are mixed, a second mixture to be injected into the second mold 810 may be prepared. A ratio of the second binder 802 injected into the second mold 810 may be referred to as a second ratio. The second ratio may be referred to as a relatively high ratio compared with the first ratio of the first binder 702 described above. For example, the second ratio may be approximately 16wt% to approximately 40wt% with respect to second metal powders injected into the second mold 810, but is not limited thereto. For example, a ratio of the binder to the first metal powders of the second mixture may be referred to as approximately 16wt% to approximately 40wt%. Other than the fact that the second ratio is in a numerical range greater than the first ratio, the first ratio and the second ratio are not limited to the numerical ranges described above. For example, the second portion 420 may be added to the inner surface of the first portion 410, and the interior of the second portion 420 may be empty. The frame 218 formed by the first portion 410 and the second portion 420 may have a substantially quadrilateral ring shape with an empty interior. According to an example embodiment, by operation 603, the second portion 420 may be coupled onto the first portion 410.

According to an example embodiment, since the second ratio is higher than the first ratio, density of the first metal powders 701 included in the first portion 410 and density of the first metal powders 801 included in the second portion 420 may be different. For example, since the first binder 702 having the first ratio, which is a relatively low ratio, is included in the first portion 410 and the second binder 802 having the second ratio, which is a relatively high ratio, is included in the second portion 420, the density of the first metal powders 801 included in the second portion 420 may be lower than the density of the first metal powders 701 included in the first portion 410.

Referring again to FIG. 6, in operation 604, a de-binding process may be performed.

The de-binding process is a process of vaporizing binder by applying high temperature heat for approximately 5 hours to approximately 20 hours. According to an example embodiment, the de-binding process may include a primary de-binding process, a secondary de-binding process, and a tertiary de-binding process. The primary de-binding process may be performed at approximately 400°C. The secondary de-binding process may be performed at approximately 500°C. The tertiary de-binding process may be performed at approximately 800°C. The tertiary de-binding process may be referred to as pre-sintering. The de-binding process described above is merely exemplary, and an embodiment is not limited thereto. For example, a temperature and a time of the de-binding process may be set based on materials of powders to be input. For example, the temperature and the time of the de-binding process may be changed according to components of the binder and a ratio of the binder. For example, the de-binding process may include only the primary de-binding process and the secondary de-binding process. While the de-binding process is performed, the binder may be removed by being vaporized, and the first metal powders (e.g., the first metal powders 701 and the first metal powders 801 of FIG. 8B) may shrink. For example, while the de-binding process is performed, a volume of the first metal powders may shrink by, for example, approximately 5% to approximately 20%. However, it is not limited thereto, and may shrink by less than approximately 5% or more than approximately 20%.

According to an example embodiment, by the de-binding process, the first binder (e.g., the first binder 702 of FIG. 8B) included in the first portion 410 may be substantially fully vaporized, but the second binder (e.g., the second binder 802 of FIG. 8B) included in the second portion 420 may remain. For example, approximately 5% to approximately 20% of the second binder included in the second portion 420 may remain after the de-binding process is completed. However, it is not limited thereto and an amount of the second binder remaining may be less than approximately 5% or more than approximately 20%. A difference in whether the binder remains may result from a difference in a ratio of the injected binder. For example, the first binder having the first ratio, which is a relatively low ratio, may be removed by being substantially fully vaporized during the de-binding process. The second binder having the second ratio, which is a relatively high ratio, may not be fully vaporized and a portion thereof may remain even after the de-binding process is completed.

In operation 605, a sintering process may be performed at a crystallization temperature of the first metal.

The sintering process is a process of coupling metal powders by heating a semi-finished product (e.g., a green body). Through the sintering process, mechanical strength, durability, and corrosion resistance may be enhanced. By the sintering process, first metal crystals may be formed as the first metal powders are coupled. The sintering process may be performed at the crystallization temperature of the first metal to crystallize the first metal. For example, when the first metal material includes titanium, the sintering process may be performed at approximately 1,668°C, which is a crystallization temperature of titanium. The crystallization temperature may vary according to a grade of titanium and is not limited to the crystallization temperature described above.

According to an example embodiment, a time during which the sintering process is performed may be set as a time required to crystallize the first metal powders included in the first portion 410. In a state in which the de-binding process described above is completed, the binder may not be substantially included in the first portion 410 but may remain in the second portion 420. While the sintering process is performed, the first metal powders included in the first portion 410 may be fully crystallized. Since the first metal powders included in the first portion 410 are fully crystallized, pores may not be formed in the first portion 410. While the sintering process is performed, the second binder included in the second portion 420 may be vaporized, and the first metal powders included in the second portion 420 may be crystallized.

According to an example embodiment, a time during which the sintering process is performed may be set as a time required to crystallize the first metal powders included in the first portion 410. As the second binder 802 included in the second portion 420 is vaporized by the sintering process and the first metal powders included in the second portion 420 are crystallized, pores (e.g., the pores 901 of FIG. 9C) may be formed. While the sintering process is performed, the volume of the first metal powders may further shrink by approximately 5% to 15%. By the de-binding process and the sintering process, the volume of the first metal powders may ultimately shrink by approximately 10% to approximately 35%. The first metal powders included in the second portion 420 may shrink during a crystallization process, and pores (e.g., the pores 901 of FIG. 9C) may be formed in an area in which the second binder 802 existed as the second binder 802 is removed. For example, the first metal powders may shrink during the crystallization process, and pores may be formed in a remaining space. According to an example embodiment, pores may be formed in the second portion 420 as the sintering process is performed. As the sintering process is completed, the frame 218 including the first portion 410 and the second portion 420 may be provided.

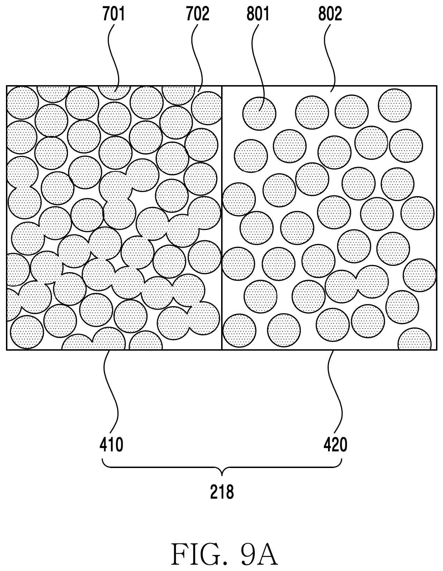

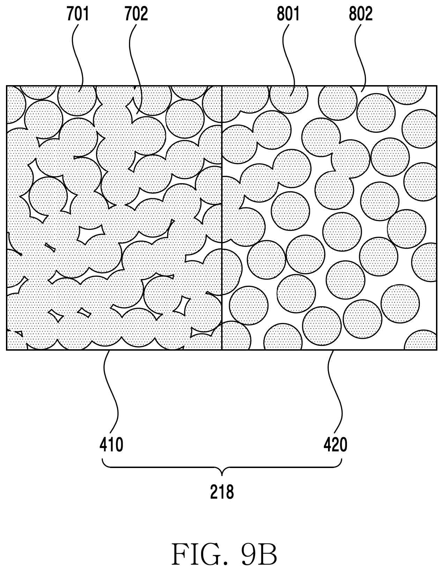

FIG. 9A illustrates an example structure of a first portion and a second portion after metal injection molding. FIG. 9B illustrates an example structure of the first portion and the second portion after a de-binding process. FIG. 9C illustrates an example structure of the first portion and the second portion after a sintering process.

The structure illustrated in FIG. 9A may be referred to as a structure of a frame 218 after operation 603 of FIG. 6 is performed.

Referring to FIG. 9A, after a first portion 410 and a second portion 420 are injected, first metal powders 701 and a first binder 702 may be included in the first portion 410, and first metal powders 801 and a second binder 802 may be included in the second portion 420. A first ratio of the first binder 702 injected to form the first portion 410 may be lower than a second ratio of the second binder 802 injected to form the second portion 420. Due to a difference in ratios of the binders, density of the first metal powders 801 included in the second portion 420 may be lower than density of the first metal powders 701 included in the first portion 410.

The structure illustrated in FIG. 9B may be referred to as the structure of the frame 218 after operation 604 of FIG. 6 is performed.

Referring to FIG. 9B, after the de-binding process is performed, the first binder 702 included in the first portion 410 may be substantially fully removed, but the second binder 802 included in the second portion 420 may remain. Since the second ratio is higher than the first ratio, while the de-binding process is performed, the second binder 802 having the second ratio may not be fully vaporized and a portion thereof may remain. After the de-binding process is performed, spaces may be formed between the first metal powders 801 included in the second portion 420 due to the second binder 802 remaining in the second portion 420.

The structure illustrated in FIG. 9C may be referred to as the structure of the frame 218 after operation 605 of FIG. 6 is performed.

Referring to FIG. 9C, after the sintering process is performed, the first metal powders 701 included in the first portion 410 may be fully crystallized. Since the first metal powders 701 included in the first portion 410 are fully crystallized, pores may not be formed in the first portion 410. The first portion 410 may have relatively high strength and may have excellent surface characteristics. After the sintering process is performed, the second binder 802 included in the second portion 420 may be removed. As described above, a time during which the sintering process is performed may be set as a time required for the first metal powders included in the first portion 410 to be fully crystallized. Binder included in the second portion 420 may be removed by being vaporized through the sintering process. As the binder (e.g., the second binder 802) included in the second portion 420 is removed and the first metal powders 801 included in the second portion 420 shrink, pores 901 may be formed in the second portion 420. As a second metal material for forming a bracket 243 infiltrates into the pores, the bracket 243 coupled to the frame 218 may be formed.

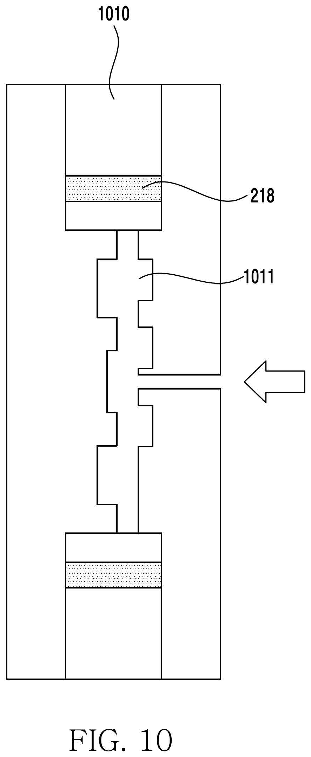

Referring again to FIG. 6, in operation 606, the frame 218 may be placed in a third mold (e.g., a third mold 1010 of FIG. 10), and the bracket 243 may be formed by die casting the second metal material into the second portion 420.

FIG. 10 illustrates an operation of forming a bracket.

Referring to FIG. 10, a bracket 243 may be formed inside a frame 218 by die casting of molten second metal. For example, the frame 218 may be placed in a third mold 1010 including a cavity 1011 corresponding to a shape of the bracket 243. The third mold 1010 illustrated in FIG. 10 is merely a mold schematically illustrated to describe a manufacturing method, and an embodiment is not limited to the drawings illustrated in FIG. 10. To perform die casting of a second metal material, molten metal may be prepared by melting the second metal material at a high temperature. For example, when the second metal material is aluminum, molten metal may be prepared by melting aluminum in a melting furnace. The molten metal of the second metal material may be injected into the cavity 1011 of the third mold 1010 corresponding to the shape of the bracket 243. The molten metal of the second metal material may be included in a second portion 420 by infiltrating into pores formed in the second portion 420. Since a first portion 410, in which first metal powders are substantially fully crystallized, does not include pores, the molten metal of the second metal material may not infiltrate into the first portion 410. After injection of the molten metal of the second metal material is completed, a cooling process is performed so that the second metal material may be solidified. After a casting of the second metal solidified by the cooling process is separated from the third mold 1010, residues may be removed and a surface may be polished so that the bracket 243 may be formed. As the cooling process is performed in a state in which the molten metal of the second metal material has infiltrated into the pores, the second metal material forming a portion of the bracket 243 may be included in the second portion 420. Since the molten metal of the second metal material does not infiltrate into the first portion 410, the second metal material forming the bracket 243 may not be included in the first portion 410. As the second metal material is included in the second portion 420, the bracket 243 may be coupled to an inside of the frame 218. The bracket 243 may be manufactured in a form at least partially surrounded by the frame 218.

In operation 607, resin may be injected into the frame 218.

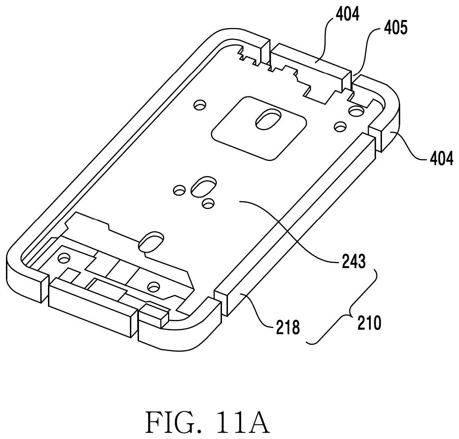

FIG. 11A illustrates a housing assembly in which a frame and a bracket are formed.

Referring to FIG. 11A, as described above, a frame 218 may include a slot 405 (or slit). When the frame 218 is entirely filled with a first metal material that is a conductive material, it may be difficult to use one or more conductive portions 404 as an antenna radiator because a resonant frequency of a signal radiated or received through the one or more conductive portions 404 of the frame 218 may not be adjusted. As the slot 405 (or slit) is formed in the frame 218, an electrical length of the one or more conductive portions 404 may be adjusted. Since the electrical length of the one or more conductive portions 404 may determine frequency characteristics of a signal transmitted and/or received through the antenna radiator, the one or more conductive portions 404 may be used as an antenna radiator for transmitting and/or receiving a signal on a specified frequency band.

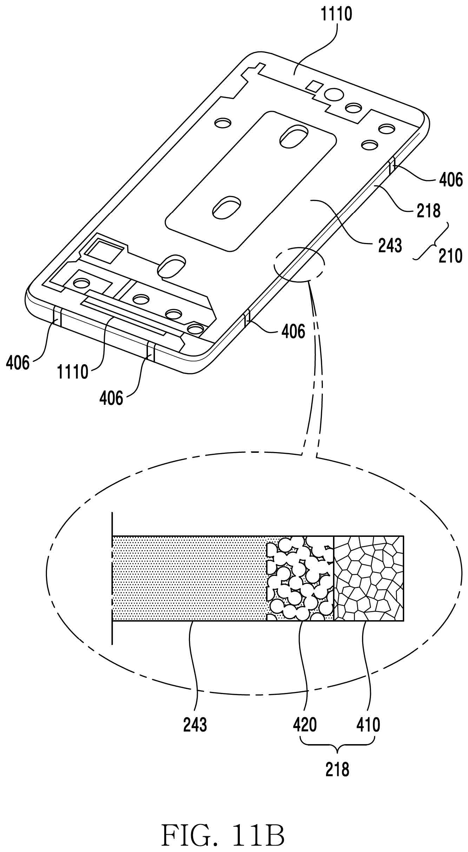

FIG. 11B illustrates the housing assembly in which resin is injected into the frame.

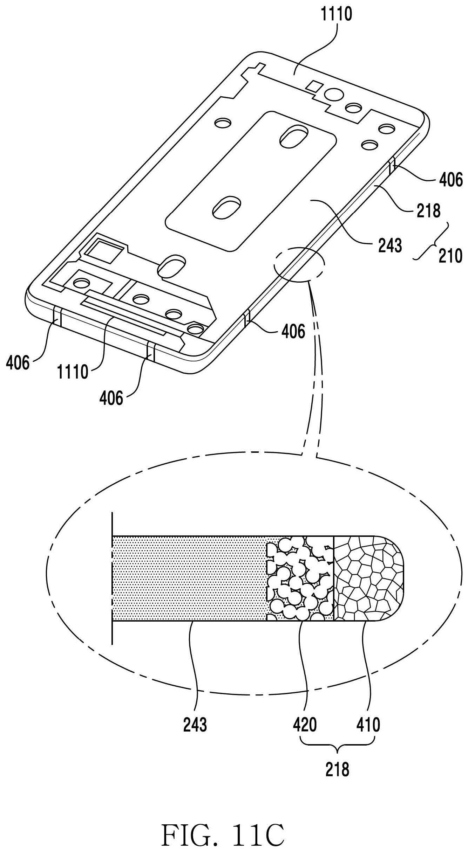

Referring to FIG. 11B, resin 1110 may be injected to fill the slot 405 (or slit) of the frame 218. As the resin 1110, which is a non-conductive material, fills at least a portion of the slot 405 (or slit), a segmented structure including one or more conductive portions 404 and one or more non-conductive portions (e.g., one or more non-conductive portions 406 of FIG. 11C) may be formed on a side surface of the housing assembly 210. The segmented structure may operate as an antenna radiator for communication with an external electronic device. For example, a wireless communication module (e.g., the wireless communication module 192 of FIG. 1) may be configured to transmit or receive a signal on a specified band using the one or more conductive portions 404 forming a portion of the side surface of the housing assembly 210.

FIG. 11C illustrates the housing assembly of a final product obtained by processing the shape of the housing assembly of FIG. 11B.

Referring to FIG. 11C, the resin 1110 may fill at least a portion of an empty space between the frame 218 and a bracket 243. After the resin is injected, processing (e.g., cutting processing) into a form of the final product may be performed, and the housing assembly 210 may be provided. For example, the resin may include polybutylene terephthalate (PBT) having excellent electrical characteristics and flame retardancy, but is not limited thereto. For example, the resin may also include polycarbonate (PC) and/or polyphthalamide (PPA). By coupling a front cover (e.g., the front cover 202 of FIG. 3) and a rear cover (e.g., the rear cover 211 of FIG. 3) to the housing assembly 210 illustrated in FIG. 11C, the housing assembly 210 used in the final product may be formed. After the processing is completed, an outer surface of the frame 218 may be partially rounded.

According to an example embodiment, the housing assembly 210 may include the frame 218 and the bracket 243. The frame 218 may include a first portion 410 and a second portion 420. For example, the first portion 410 may at least partially form the outer surface of the frame 218. The first portion 410 may be formed of a first metal material that is substantially fully crystallized and thus may have relatively high strength and excellent surface characteristics. Since the first portion 410 is difficult to be damaged by an external impact, strength of an electronic device 101 may be improved. The second portion 420 may be disposed on the first portion 410. Through a de-binding process and a sintering process, the second portion 420 may be coupled to the first portion 410. As a second metal material that has infiltrated into pores is coupled to the second portion 420, the bracket 243 may be firmly coupled to the frame 218. An example electronic device 101 may have a coupling structure between the frame 218 and the bracket 243 resulting from solidification of the second metal material that has infiltrated into the pores, without a need to form a separate concavo-convex portion or adjust roughness on an inner surface of the frame 218 for coupling through die casting. The manufacturing method described above may improve coupling force between the frame 218 and the bracket 243 and may reduce unnecessary processes, thereby reducing manufacturing cost.

According to an example embodiment, the frame 218 and the bracket 243 may include metals different from each other. The frame 218 exposed to an outside of the electronic device 101 may include the first metal material (e.g., titanium) having relatively high strength for rigidity of the electronic device 101. The bracket 243, which is disposed inside the electronic device 101 and is not exposed to the outside, may include the second metal material (e.g., aluminum) having relatively low specific gravity for weight lightening of the electronic device 101. An example electronic device 101 may achieve weight lightening while having high rigidity.

In the above description, the frame 218 and the bracket 243 have been described as separate components, but may be regarded as one component in terms of the bracket 243 being integrally coupled to the frame 218. For example, the electronic device 101 may include a bracket including a frame portion and a supporting portion. The frame portion of the bracket may correspond to the frame 218 described above. The supporting portion of the bracket may correspond to the bracket 243 described above.

An electronic device 101 is provided. The electronic device 101 may comprise a housing assembly 210. The housing assembly 210 may include a rear cover 211 defining a rear surface of the electronic device 101. The housing assembly 210 may include a frame 218 attached to the rear cover 211 and formed from a first metal material. The frame 218 may include a first portion 410 defining a side surface of the electronic device 101. The frame 218 may include a second portion 420 disposed on an inner surface of the first portion 410. The housing assembly 210 may include a bracket 243 including a supporting portion 243a and formed from a second metal material different from the first metal material. The electronic device 101 may comprise a display 201 supported by the supporting portion 243a. The second portion 420 of the frame 218 may be disposed between the first portion 410 and the supporting portion 243a. A portion of the second metal material of the bracket may be inserted into some of pores 901 included in the second portion 420.

For example, the first metal material may comprise titanium. The second metal material may comprise aluminum.

For example, the second portion 420 of the frame 218 may comprise titanium with the pores 901 filled with aluminum.

For example, density of the first metal material included in the second portion 420 may be lower than density of the first metal material included in the first portion 410.

For example, the bracket 243 may be configured to support one or more electronic components.

For example, a portion of the bracket 243 may couple the bracket 243 to the second portion 420, by being inserted into some of the pores between crystals of the first metal material, included in the second portion 420.

For example, thickness of the second portion 420 may be 10% to 70% of thickness of the frame 218.

For example, specific gravity of the second metal material may be lower than specific gravity of the first metal material.

For example, the second metal material may be included in the second portion 420 and may be excluded from the first portion 410.

For example, minimum coupling strength between the bracket 243 and the frame 218 may be 10 MPa or more.

A method of manufacturing a housing assembly 210 is provided. The manufacturing method may comprise injecting a first mixture of first metal powders and binder using a first mold 710 to form a first portion 410. The manufacturing method may comprise separating the first portion 410 from the first mold 710. The manufacturing method may comprise placing the first portion 410 in a second mold 810. The manufacturing method may comprise forming a second portion 420 on an inner surface of the first portion 410 by injecting a second mixture of the first metal powders and binder using the second mold 810. The manufacturing method may comprise performing de-binding to remove the binder included in the first portion 410 and the binder included in the second portion 420 such that an amount of the binder remaining in the second portion 420 is greater than an amount of the binder remaining in the first portion 410. The manufacturing method may comprise forming a frame 218 by performing sintering to the first portion 410 and the second portion 420 after the de-binding is performed. The manufacturing method may comprise placing the frame 218 in a third mold 1010. The manufacturing method may comprise forming a bracket 243 by die casting of molten second metal using the third mold 1010 with the frame 218 placed therein to integrally form the bracket 243 to an inner side of the second portion 420 of the frame 218. The second mixture may have a ratio of the binder to the first metal powders that is greater than a ratio of the binder to the first metal powders of the first mixture.

For example, a portion of the binder included in the second portion 420 may remain after the de-binding is performed. The binder included in the first portion 410 may be removed while the de-binding is performed.

For example, the portion of the binder included in the second portion 420 remaining after the de-binding is performed may be removed while the sintering is performed.

For example, pores 901 may be formed in the second portion 420 by the portion of the binder included in the second portion 420 being removed.

For example, pores 901 may be formed in the second portion 420 by the sintering. When die casting the molten second metal, the bracket 243 coupled to the second portion 420 may be formed by the second metal material being inserted into the pores 901.

For example, a ratio of the binder to the first metal powders of the first mixture may be 5wt% to 15wt%. A ratio of the binder to the first metal powders of the second mixture may be 16wt% to 40wt%.

For example, the first metal material may comprise titanium. The second metal material may comprise aluminum.

For example, minimum coupling strength between the bracket 243 and the frame 218 may be 10 MPa or more.

For example, specific gravity of the second metal material may be lower than specific gravity of the first metal material.

For example, density of the first metal material included in the second portion 420 may be lower than density of the first metal material included in the first portion 410.

An electronic device 101 is provided. The electronic device 101 may comprise a bracket including a frame portion (e.g., a frame 218) and a supporting portion (e.g., a bracket 243). The frame portion may be formed from a first metal material. The frame portion may include a first portion and a second portion. The first portion may define a side surface of the electronic device. The second portion may be disposed on an inner surface of the first portion. The supporting portion may be formed from a second metal material. The supporting portion may support a display 201 of the electronic device 101. A portion of the second metal material of the supporting portion may be inserted into some of pores 901 included in the second portion.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
a housing assembly including:
a rear cover defining a rear surface of the electronic device,
a frame attached to the rear cover and formed from a first metal material, the frame including:
a first portion, defining a side surface of the electronic device, and
a second portion disposed on an inner surface of the first portion, and
a bracket including a supporting portion and formed from a second metal material different from the first metal material; and
a display supported by the supporting portion,
wherein the second portion of the frame is disposed between the first portion of the frame and the supporting portion of the bracket, and
wherein a portion of the second metal material of the bracket is inserted into some of pores included in the second portion.

2. The electronic device of claim 1, wherein the first metal material comprises titanium, and
wherein the second metal material comprises aluminum.

3. The electronic device of claim 2, wherein the second portion of the frame comprises titanium with the pores filled with aluminum.

4. The electronic device of any one of claims 1 to 3, wherein density of the first metal material included in the second portion of the frame is lower than density of the first metal material included in the first portion of the frame.

5. The electronic device of any one of claims 1 to 4, wherein the bracket is configured to support one or more electronic components.

6. The electronic device of any one of claims 1 to 5, wherein a portion of the bracket couples the bracket to the second portion, by being inserted into some of the pores between crystals of the first metal material, included in the second portion.

7. The electronic device of any one of claims 1 to 6, wherein thickness of the second portion is 10% to 70% of thickness of the frame.

8. The electronic device of any one of claims 1 to 7, wherein specific gravity of the second metal material is lower than specific gravity of the first metal material.

9. The electronic device of any one of claims 1 to 8, wherein the second metal material is included in the second portion and is excluded from the first portion.

10. The electronic device of any one of claims 1 to 9, wherein minimum coupling strength between the bracket and the frame is 10 MPa or more.

11. A method of manufacturing a housing assembly, the method of manufacturing comprising:
injecting a first mixture of first metal powders and binder, using a first mold to form a first portion;
separating the first portion from the first mold;
placing the first portion in a second mold;
forming a second portion on an inner surface of the first portion by injecting a second mixture of the first metal powders and binder, using the second mold;
performing de-binding to remove the binder included in the first portion and the binder included in the second portion such that an amount of the binder remaining in the second portion is greater than an amount of the binder remaining in the first portion;
forming a frame by performing sintering to the first portion and the second portion after the de-binding is performed;
placing the frame in a third mold; and
forming a bracket by die casting of molten second metal, using the third mold with the frame placed therein to integrally form the bracket to an inner side of the second portion of the frame,
wherein the second mixture has a ratio of the binder to the first metal powders that is greater than a ratio of the binder to the first metal powders of the first mixture.

12. The manufacturing method of claim 11,
wherein a portion of the binder included in the second portion remains after the de-binding is performed, and
wherein the binder included in the first portion is removed while the de-binding is performed.

13. The manufacturing method of claim 12,
wherein the portion of the binder included in the second portion remaining after the de-binding is performed is removed while the sintering is performed.

14. The manufacturing method of any one of claims 11 to 13,
wherein pores are formed in the second portion by the sintering, and
when die casting the molten second metal, the bracket coupled to the second portion is formed by the second metal material being inserted into the pores.

15. The manufacturing method of any one of claims 11 to 14,
wherein a ratio of the binder to the first metal powders of the first mixture is 5wt% to 15wt%, and
wherein a ratio of the binder to the first metal powders of the second mixture is 16wt% to 40wt%.
